Europäisches Patentamt

European Patent Office

Office européen des brevets

(19)

(11) **EP 1 586 681 A1**

(12) **EUROPEAN PATENT APPLICATION**
published in accordance with Art. 158(3) EPC

(43) Date of publication:
**19.10.2005 Bulletin 2005/42**

(21) Application number: **04700763.8**

(22) Date of filing: **08.01.2004**

(51) Int Cl.[7]: **C30B 29/16**, C01G 23/07

(86) International application number:
**PCT/JP2004/000073**

(87) International publication number:
**WO 2004/063431 (29.07.2004 Gazette 2004/31)**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **09.01.2003 JP 2003003049**
**19.09.2003 JP 2003328915**
**01.12.2003 JP 2003401493**

(71) Applicant: **FUJIKURA LTD.**
**Kohtoh-ku, Tokyo 135-8512 (JP)**

(72) Inventors:
• **TERADA, Yoshihiro, c/o Fujikura Ltd.**
**Sakura-shi, Chiba 285-8550 (JP)**

• **KAMIKATANO, Mitsuru, c/o Fujikura Ltd.**
**Sakura-shi, Chiba 285-8550 (JP)**
• **HE, Jialei, c/o Fujikura Ltd.**
**Sakura-shi, Chiba 285-8550 (JP)**
• **HIMENO, Kuniharu, c/o Fujikura Ltd.**
**Sakura-shi, Chiba 285-8550 (JP)**

(74) Representative: **Carter, Stephen John**
**Mewburn Ellis LLP**
**York House**
**23 Kingsway**
**London WC2B 6HP (GB)**

(54) **TITANIUM OXIDE GRAIN, PROCESS AND APPARATUS FOR PRODUCING THE SAME, AND METHOD OF TREATING WITH THE TITANIUM OXIDE**

(57)     A particulate titanium oxide is obtained which has a large specific surface area per unit weight and a high crystallinity with few internal defects, and thus a high photocatalytic activity as a photocatalyst is expected. Also obtained is a particulate titanium oxide which, even when heated to an elevated temperature, does not easily transform to a rutile-type crystal structure and in which sintering does not readily proceed.

Particulate titanium oxide in which the particles are box-shaped polyhedra is used as the photocatalyst. The particles of titanium oxide are each a box-shaped polyhedron composed of one or more titanium oxide single-crystal polyhedron. When this single-crystal polyhedron has a flatness ratio of 0.33 to 3.0, the crystallinity is even higher.

It is preferable for the polyhedron to have from six to ten faces. The particulate titanium oxide typically has a rutile transition ratio R(700-24) of not more than 7.5% and a rutile transition ratio R(500-24) of not more than 2.0%. Titanium oxide particles of these shape characteristics are manufactured by feeding titanium tetrachloride vapor and oxygen into a reaction tube made of silica glass and applying heat from outside the tube with an oxyhydrogen flame burner to effect thermal oxidation.

FIG. 1

**Description**

BACKGROUND ART

The present invention relates to particulate titanium oxide which can be used in photocatalysts and other applications, to a method and an apparatus for manufacturing particulate titanium oxide, and to treatment methods which make use of such titanium oxide. By having the particulate titanium oxide consist of particles of a novel shape, the photocatalytic activity of the titanium oxide when used as a photocatalyst is greatly increased.

Photocatalysts composed of particulate titanium oxide are well known. Photocatalytic reactions by particulate titanium oxide are chemical reactions which arise at the surface of the titanium oxide particles. The reactions start with adsorption of the chemical substance to be decomposed to the surface of the titanium oxide particles. Hence, the smaller the particle size of the particulate titanium oxide, the higher the photocatalytic activity it exhibits.

In prior inventions disclosed in Japanese Unexamined Patent Application, First Publication No.H1-267519, Japanese Unexamined Patent Application, First Publication No.H 08-164334 and Japanese Unexamined Patent Application, First Publication No.H 07-303835, particulate titanium oxide that has been brought down in size to a particle diameter on the order of several nanometers is regarded as desirable. However, problems with dispersibility are sometimes encountered when such a finely divided nano-particulate titanium oxide is prepared as a slurry.

Particulate titanium oxide commercially sold for photocatalyst applications all have a spherical particle shape. The specific surface area per unit weight is thus small, which may result in a lower than desirable reactivity.

The photocatalytic activity of titanium oxide works as follows. The irradiation of particulate titanium oxide with light excites electrons within the titanium oxide, resulting in the formation of excited electrons ($e^-$) and holes ($h^+$), which gives rise to an oxidizing or reducing ability.

However, it is known that some of the excited electrons and holes recombine at defects within the titanium oxide as the recombination centers, lowering the photocatalytic activity.

Particulate titanium oxide having few interior defects is thus desirable. Japanese Unexamined Patent Application, First Publication No.2001-276615 discloses large-diameter anatase single crystals which exhibit a high catalytic activity.

Yet, particulate titanium oxide having a high crystallinity and a small particle size cannot be obtained by prior-art production methods. The only way to obtain highly crystalline particles having few internal defects has been to increase the particle size at the expense of the specific surface area. As a result, the particulate titanium oxide disclosed in above-mentioned Japanese Unexamined Patent Application, First Publication No.2001-276615 has a low adsorption of the chemical substance to be decomposed and is thus poorly suited for use as a photocatalyst.

Japanese Unexamined Patent Application, First Publication No.H 10-081517 and Japanese Unexamined Patent Application, First Publication No.H 10-095617 disclose particulate titanium oxides having other than spherical particle shapes, such as needle-like, dendritic, star-like or plate-like shapes, for use in such applications as pigments and shielding. However, particulate titanium oxides having such shapes differ markedly from those with a crystal shape inherent to titanium oxide. Namely, the particles have a structure with a greatly reduced crystallinity that is nearly amorphous and inevitably contains many internal defects.

Accordingly, to date, no known particulate titanium oxides have had a large specific surface area per unit weight, a high crystallinity with few internal defects, and been suitable for use as a photocatalyst.

Known methods for preparing particulate titanium oxide include the liquid phase process described in Japanese Unexamined Patent Application, First Publication No.H05-163022 and the vapor phase process described in Japanese Unexamined Patent Application, First Publication No.2001-276615. However, these processes are unable to synthesize particulate titanium oxide which has a large specific surface area per unit weight and a high crystallinity with few internal defects, and which is suitable for use as a photocatalyst.

Moreover, to have a particulate titanium oxide actually function as a photocatalyst, it is necessary to support the particles of titanium oxide on a substrate and efficiently bring them into contact with the substance to be decomposed. One approach for supporting this particulate titanium oxide on a substrate is exemplified by methods like that described in Japanese Unexamined Patent Application, First Publication No.H07-002522, in which the particles are directly fired onto a substrate composed of an inorganic material. In this method, a material such as low-melting glass is used as the binder and firing is carried out by heating to a temperature at which the binder softens and melts, generally about 700°C.

Another method, described in Japanese Patent No.3279755, involves immobilizing the particulate titanium oxide on the substrate using an organic binder such as a synthetic resin. It is necessary in this method to select and use as the organic binder a synthetic resin which is not readily degraded by titanium oxide and will solidify under not more than several hours of heating at about 500°C.

However, because these methods of supporting particulate titanium oxide all involve the application of heat to a temperature of about 500 to 700°C, the crystal structure of the titanium oxide changes.

Titanium oxide employed as a photocatalyst has an anatase-type crystal structure. The reason is that anatase-type titanium oxide has a better photocatalytic activity than titanium oxides of the other crystal structures: rutile and brookite.

Yet, it is generally known that when particulate titanium oxide having an anatase-type crystal structure is supported in the above manner, heating to about 500 to 700°C will transform the crystal structure into the rutile-type, lowering the photocatalytic activity.

Moreover, during such heating, the titanium oxide particles mutually sinter, which reduces their surface area and also contributes to a decline in the photocatalytic activity.

It is therefore an object of the present invention to obtain particulate titanium oxide which has a large specific surface area and a high crystallinity with few internal defects and can thus achieve a high photocatalytic activity as a photocatalyst. Additional objects of the invention are to obtain a method and an apparatus for manufacturing such particulate titanium oxide. A further object of the invention is to obtain particulate titanium oxide which undergoes little transition into a rutile-type crystal structure even when heated to a high temperature, and in which sintering does not readily proceed even with the application of heat. A still further object of the invention is to obtain methods of use, such as methods for decomposing noxious substances, which utilize such particulate titanium oxide and have excellent treatment effects.

DISCLOSURE OF INVENTION

The following inventions are provided to achieve these objects.

The invention of claim 1 is a particulate titanium oxide comprising particles which are each a box-shaped polyhedron composed of one or more single crystalline polyhedron, and which have a particle size of 1 to 500 nm.

The invention of claim 2 is the particulate titanium oxide of claim 1, wherein the single crystalline polyhedron has a flatness ratio of 0.33 to 3.0.

The invention of claim 3 is the particulate titanium oxide of claim 1, wherein the polyhedron has from six to ten faces.

The invention of claim 4 is the particulate titanium oxide of any one of claims 1 to 3 which has a rutile transition ratio R(700-24) of not more than 7.5% and a rutile transition ratio R(500-24) of not more than 2.0%.

The invention of claim 5 is the particulate titanium oxide of any one of claims 1 to 4, wherein the particle size is from 100 to 500 nm.

The invention of claim 6 is the particulate titanium oxide of any one of claims 1 to 5 which has a specific surface area of 3 to 40 $m^2$/g, and for which, when 5 ml of a 5% by volume aqueous solution of acetic acid and 50 mg of the particulate titanium oxide are placed in a sealed container having an inside diameter of 15 mm and, in a suspended state, are irradiated with 365 nm ultraviolet light at an exposure dose of 15 mW/$cm^2$, the rate of carbon dioxide evolution per hour lies in the region above the line represented by y = 0.8x (wherein x is the specific surface area in $m^2$/g, and y is the rate of carbon dioxide evolution in μmol/hr).

The invention of claim 7 is the particulate titanium oxide of any one of claims 1 to 5 which is doped with silicon, has a specific surface area of 3 to 40 $m^2$/g, and for which, when 5 ml of a 5% by volume aqueous solution of acetic acid and 50 mg of the particulate titanium oxide are placed in a sealed container having an inside diameter of 15 mm and, in a suspended state, are irradiated with 365 nm ultraviolet light at an exposure dose of 15 mW/$cm^2$, the rate of carbon dioxide evolution per hour lies in the region above the line represented by y = 0.8x (wherein x is the specific surface area in $m^2$/g, and y is the rate of carbon dioxide evolution in μmol/hr).

The invention of claim 8 is a titanium oxide powder comprising an aggregation of numerous particulate titanium oxide of any one of claims 1 to 7, wherein anatase crystals account for at least 80% of the titanium oxide particles making up the powder.

The invention of claim 9 is the titanium oxide powder of claim 8, wherein anatase crystals account for at least 90% of the particles.

The invention of claim 10 is a method of manufacturing particulate titanium oxide which is characterized by feeding a titanium compound vapor and oxygen into a reaction tube and applying heat from outside the tube.

The invention of claim 11 is the method of manufacturing particulate titanium oxide of claim 10 which is characterized by using an oxyhydrogen flame burner as the heating source.

The invention of claim 12 is the method of manufacturing particulate titanium oxide of claim 10 or 11 which is characterized by rotating the reaction tube.

The invention of claim 13 is the method of manufacturing particulate titanium oxide of claim 10 which is characterized by providing in the reaction tube a cylindrical member for guiding a mixed gas of the titanium compound vapor and the oxygen to an inner wall side of the reaction tube, and by applying heat from outside the tube.

The invention of claim 14 is the method of manufacturing particulate titanium oxide of claim 13 which is characterized by providing a gap of 0.1 to 10 mm between the reaction tube and the cylindrical member.

The invention of claim 15 is the method of manufacturing particulate titanium oxide of any one of claims 10 to 14 which is characterized in that the particulate titanium oxide which has been produced is collected by using a thermophoretic effect to make it accumulate in a downstream portion of the reaction tube.

The invention of claim 16 is the method of manufacturing particulate titanium oxide of any one of claims 10 to 14 which is characterized in that the particulate titanium oxide which has been produced is collected using a bag filter provided on the downstream side of the reaction tube.

The invention of claim 17 is an apparatus of manufacturing particulate titanium oxide which comprises a reaction tube, a heating source for heating the reaction tube from the outside thereof, a rotary drive unit which rotates the reaction tube about its own axis, and a raw material feed unit which feeds a titanium compound vapor and oxygen into the reaction tube.

The invention of claim 18 is the particulate titanium oxide manufacturing apparatus of claim 17 which additionally comprises a bag filter that collects particulate titanium oxide which has been produced within the reaction tube.

The invention of claim 19 is the particulate titanium oxide manufacturing apparatus of claim 17 of 18, wherein a cylindrical member that guides a mixed gas of the titanium compound vapor and the oxygen to an inner wall side of the reaction tube is provided within the reaction tube.

The invention of claim 20 is a photocatalyst comprised of the particulate titanium oxide of any one of claims 1 to 7.

The invention of claim 21 is a photocatalyst comprised of the titanium oxide powder of claim 8 or 9.

The invention of claim 22 is a coating which contains the particulate titanium oxide of any one of claims 1 to 7.

The invention of claim 23 is a coating which contains the titanium oxide powder of claim 8 or 9.

The invention of claim 24 is a photocatalytic device comprising a photocatalytic reactant which supports on a surface thereof the particulate titanium oxide of any one of claims 1 to 7, and a light source which directs light at the photocatalytic reactant.

The invention of claim 25 is a method of decomposing noxious substances using the titanium oxide powder of claim 8 or 9.

The invention of claim 26 is the noxious substance decomposing method of claim 25, wherein decomposition is carried out by contacting particulate titanium oxide with a material to be treated, then separating off the particulate titanium oxide with a filter.

The invention of claim 27 is the noxious substance decomposing method of claim 26, wherein the filter is made of glass fibers and has a pore size of at least 2.0 µm.

The invention of claim 28 is a deodorizing method which uses the photocatalyst of claim 20 or 21.

The invention of claim 29 is a sterilizing method which uses the photocatalyst of claim 20 or 21.

The invention of claim 30 is a method of decomposing noxious substances which uses the photocatalyst of claim 20 or 21.

In the particulate titanium oxide of the invention, because the particles are box-shaped polyhedra, the titanium oxide has a high crystallinity with few internal defects or surface defects, and also has a large specific surface area per unit weight. Particles composed of a single crystalline polyhedron having a flatness ratio within a range of 0.33 to 3.0 are especially preferred because such particles have an even larger specific surface area and a higher crystallinity. Even when heated, the particulate titanium oxide of the invention does not easily transform from a high-activity anatase-type crystal structure to a low-activity rutile-type crystal structure, and sintering does not readily proceed.

Hence, in a photocatalyst composed of such particulate titanium oxide, the rate of recombination by excited electrons and holes decreases and the surface area for adsorbing the substance to be decomposed increases, resulting in a very high photocatalytic activity. Moreover, there is no decline in the photocatalytic activity due to heat treatment incurred when the particulate titanium oxide is supported on a substrate.

The method and apparatus for manufacturing particulate titanium oxide according to the invention are able to efficiently produce particulate titanium oxide, the particles of which are individually a box-shaped polyhedron as described above.

Furthermore, the photocatalyst, coating and photocatalytic device of the invention utilize the above-described titanium oxide powder and have a high noxious substance decomposing efficiency. They also have high deodorizing and sterilizing effects.

BRIEF DESCRIPTION OF THE DRAWINGS

FIG. 1 is a schematic perspective view of an example of a box-shaped polyhedral titanium oxide particle according to the invention.
FIG. 2 is a schematic perspective view showing an example of a single crystalline polyhedron which makes up the titanium oxide particles of the invention.

FIG. 3 is a graph showing the relationship between the surface area of particulate titanium oxides according to the invention and the amount of acetic acid decomposition.

FIG. 4 is a schematic structural view showing an embodiment of an apparatus for manufacturing particulate titanium oxide according to the invention.

FIG. 5 is a schematic structural view showing another embodiment of an apparatus for manufacturing particulate titanium oxide according to the invention.

FIG. 6 is a schematic structural view showing the preferred features in yet another embodiment of an apparatus for manufacturing particulate titanium oxide according to the invention.

FIG. 7 is a schematic structural view showing an embodiment of an apparatus such as can be used in the method of decomposing noxious substances according to the invention.

FIG. 8 is an electron micrograph showing the shape of titanium oxide particles obtained in Example 1.

FIG. 9 is a graph showing the results obtained in Example 2.

FIG. 10 is an electron micrograph of titanium oxide particles after being heated in Comparative Example 3.

FIG. 11 is a graph showing the results obtained in Example 5.


BEST MODE FOR CARRYING OUT THE INVENTION


Particulate Titanium Oxide:

The particulate titanium oxide of the invention is described more fully below.

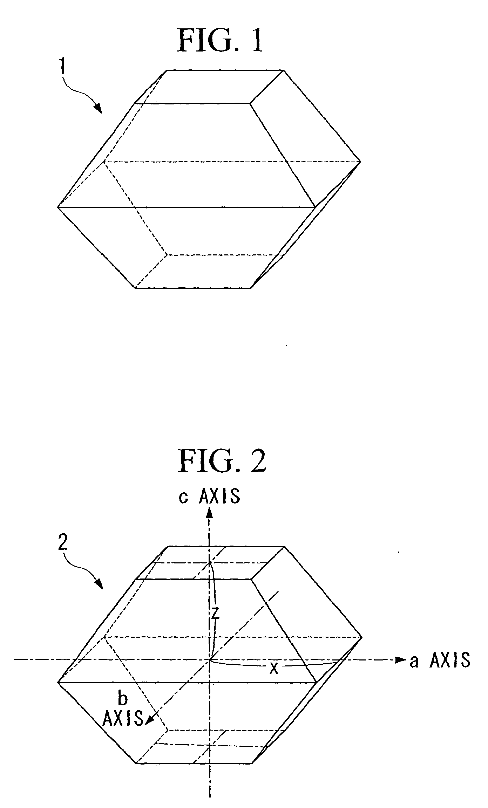

FIG. 1 is a schematic perspective view of an example of a titanium oxide particle according to the invention. The titanium oxide particle 1 in this example is a decahedral box-like shape.

"Box-shaped polyhedron," as used herein, refers to a polyhedron in which it can be presumed that the faces of a tetragonal titanium oxide crystal are reflected in the external shape of the particle.

The box-shaped polyhedral titanium oxide particles are each composed of one titanium oxide single crystalline polyhedron (single crystalline polyhedron) or an assemblage of a plurality of such polyhedra, the shape of the particle varying from a hexahedron to a polyhedron having more than six sides according to the number of such assembled single crystalline polyhedra. All such shapes are encompassed by the term "box-shaped polyhedron" as used in the present invention. The single crystalline polyhedron itself may be a polyhedron having six or more faces, including a decahedron, all of these also being encompassed by the term "polyhedron" as used in the invention.

Of these polyhedra, a decahedron like that shown in FIG. 1 is most preferred.

Moreover, taking a hexahedron as an example of the box-shaped polyhedron, even a hexahedron with a shape in which the corners are slightly chipped or slightly rounded can be regarded as basically a complete hexahedron that has been thermally or mechanically deformed, and so is encompassed herein by the term "hexahedron".

Furthermore, a decahedron in portions of which defects have arisen during crystal growth and whose shape has changed slightly due to the presence of raised or recessed features, for example, is likewise encompassed by the term "decahedron" as used in the invention, provided it has the subsequently described effects. As this polyhedron, polyhedra having from six to ten faces have high crystallinity, and are more preferable than polyhedra having higher number of faces.

Titanium oxide has three crystalline forms: anatase, rutile and brookite. In the box-shaped polyhedral titanium oxide particles of the invention, when an aggregate of numerous such titanium oxide particles compose a powder, at least 80%, and preferably at least 90%, of the particles making up the powder are composed of anatase crystals, and not more than 20%, and preferably not more than 10%, are composed of rutile crystals.

Anatase and rutile crystals both belong to the tetragonal system. In a tetragonal crystal, the **a** axis and the **b** axis are equal to each other, and so the **a** axis, **b** axis and **c** axis inherent to titanium oxide are determinable even in polyhedra other than hexahedra.

FIG. 2 shows an example of the single crystalline polyhedron 2 making up the box-shaped polyhedral titanium oxide particles of the invention. Letting the distance from the center of this single crystalline polyhedron 2 to the face or edge that intersects perpendicularly with the a axis be X, the distance to the face or edge that intersects perpendicularly with the c axis be Z, and defining the flatness ratio H of the single crystalline polyhedron as $H = X/Z$, a titanium oxide particle composed of a single crystalline polyhedron having a flatness ratio H of 0.33 to 3.0, and preferably 0.6 to 1.67, has a high photocatalytic activity and is thus preferred.

If the box-shaped polyhedron is composed of a plurality of single crystalline polyhedra, it may be considered in terms of the individual constituent single crystalline polyhedra by computing the flatness ratio in the same way for each single crystalline polyhedron and taking the average thereof. Actual measurement of the flatness ratio is carried out by examining a scanning electron micrograph of synthesized titanium oxide particles, measuring the dimensions of the single crystalline polyhedra making up a particle, determining the X and Z values, and from these, calculating the flatness ratio.

The dimensions of the box-shaped polyhedral titanium oxide particle of the invention are as follows. The average particle size is 1 to 500 nm, preferably 1 to 200 nm, more preferably 1 to 90 nm, even more preferably 10 to 70 nm, and most preferably 10 to 50 nm. Expressed as a particle size distribution, particles having a size of at least 10 nm but not more than 100 nm, and preferably at least 10 nm but not more than 40 nm, account for 85% of all the particles. The range in the particle size of the particulate titanium oxide is set as appropriate for the intended use, with the average size of the titanium oxide particles being suitably selected from a range of 1 to 500 nm.

The particulate titanium oxide of the invention undergoes very little transition to the rutile-type crystal structure when heated. In this invention, the transition to the rutile-type is evaluated as the rutile transition ratio R(700-24) and the rutile transition ratio R(500-24).

"Rutile transition ratio R(700-24)" is defined as

$$[A(before) - A(after)]/A(before) \times 100.$$

Here, "A(before)" is the proportion of titanium oxide particles having an anatase-type crystal structure before heating the particulate titanium oxide at 700°C for 24 hours, expressed as a percentage (%), and "A(after)" is the proportion of titanium oxide particles having an anatase crystal structure after heating (%).

"Rutile transition ratio R(500-24)," aside from being the transition ratio when the particulate titanium oxide has been heated at 500°C for 24 hours, is defined in the same way as above.

The proportion of titanium oxide particles having an anatase-type crystal structure is determined from peak intensities obtained in x-ray diffractometry.

In the particulate titanium oxide of the invention, the rutile transition ratio R(700-24) is not more than 7.5%, and preferably not more than 5.0%, and the rutile transition ratio R(500-24) is not more than 2.0%, and preferably not more than 1.0%.

In the particulate titanium oxide of the invention, the advance of sintering during heating is largely suppressed, thus enabling a decline in the specific surface area on account of heat treatment to be prevented. This is presumably attributable to the high crystallinity of the titanium oxide particles.

In this particulate titanium oxide, each polyhedral particle is composed of one or more single crystalline polyhedron, and so it has an excellent crystallinity with few internal or surface defects. Moreover, because the particles each have a box-like shape like that shown in FIG. 1, these particles have a larger specific surface per unit weight than conventional spherical titanium oxide particles.

Single crystalline polyhedra with a flatness ratio in a range of 0.33 to 3.0, and especially 0.6 to 1.6, have an even higher crystallinity. Hence, a photocatalyst composed of this particulate titanium oxide will exhibit a much higher photocatalytic activity than prior-art photocatalysts.

Moreover, in such a particulate titanium oxide, the rutile transition ratio is small, so transformation to the rutile-type crystal structure by heating is extremely limited, in addition to which sintering between particles is suppressed. As a result, there is no loss in the high catalytic activity even from heat treatment when this particulate titanium oxide is supported on the substrate.

Also, even though the particulate titanium oxide of the invention has a smaller surface area than prior-art particulate titanium oxide, it has a high photocatalytic activity on account of its high crystallinity.

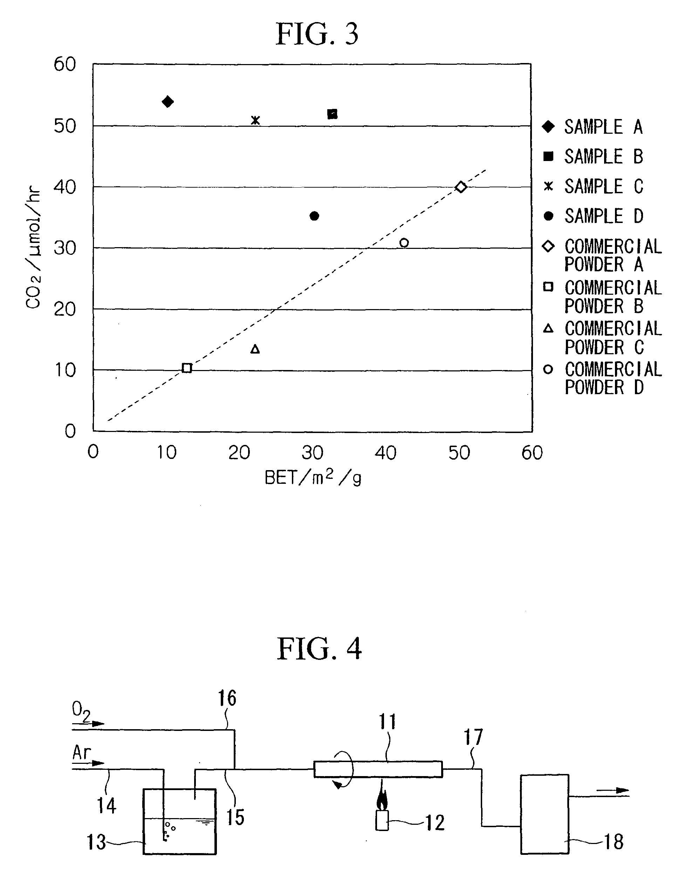

Specifically, the specific surface area, as determined by the BE method, is in a range of 3 to 40 $m^2$/g. The photocatalytic activity is such that, when 5 ml of a 5% by volume aqueous solution of acetic acid and 50 mg of the particulate titanium oxide are placed in a sealed container having an inside diameter of 15 mm and, in a suspended state, are irradiated with 365 nm ultraviolet light at an exposure dose of 15 mW/$cm^2$, the rate of carbon dioxide evolution per hour lies in the region above the line represented by y = 0.8x in FIG. 3 (wherein x is the specific surface area in $m^2$/g, and y is the rate of carbon dioxide evolution in μmol/hr), and preferably at least 40 μmol. Particulate titanium oxide doped with silicon has a photocatalytic activity such that the rate of carbon dioxide evolution obtained under the same test conditions lies in the region above the line represented by y = 0.8x in FIG. 3 (wherein x is the specific surface area, and y is the rate of carbon dioxide evolution), and preferably at least 30 μmol but not more than 45 μmol.

In conventional commercially available particulate titanium oxide, the surface area is at least 50 $m^2$/g to provide a sufficient photocatalytic activity, but such a product is difficult to manufacture. By contrast, the particulate titanium oxide of the invention has a low surface area, yet exhibits a high catalytic activity and is easy to manufacture.

The acetic acid used as the substrate to specify the photocatalytic activity is decomposed by photocatalytic action to carbon dioxide, enabling the degree of catalytic activity to be determined by measuring the rate of carbon dioxide evolution. When, as described above, 5 ml of a 5% by volume aqueous solution of acetic acid and 50 mg of the particulate titanium oxide are placed in a sealed container having an inside diameter of 15 mm and, in a suspended state, are irradiated with 365 nm ultraviolet light at an exposure dose of 15 mW/$cm^2$, it is apparent from FIG. 3 that commercially available particulate titanium oxide (conventional product) and the particulate titanium oxide of the invention have widely differing photocatalytic activities in terms of the rate of carbon dioxide evolution per hour.

Under these test conditions, because the surface area irradiated by ultraviolet light is fixed, the amount of excitation light received by the titanium oxide particles is the same and so the amount of decomposition is determined by the ability of the particulate titanium oxide to adsorb the substance to be decomposed. Consequently, in the characteristic values for conventional particulate titanium oxide, the rate of carbon dioxide evolution is proportional to the specific surface area of the of the particulate titanium oxide.

Conventional particulate titanium oxide, when measured under these test conditions, have characteristic values which, when plotted as a graph of the specific surface area (X axis) versus the rate of carbon dioxide evolution (Y axis), fall on or below the line $y = 0.8x$. These results show that it has only been possible with conventional manufacturing methods to produce particulates having characteristic values located on or below this line.

However, in the case of the titanium oxide particulates according to the invention, which are represented as samples A to D in FIG. 3, characteristic values situated above this line are obtained; within a specific surface area range of 3 to 40 $m^2/g$, the rate of carbon dioxide evolution per hour is at least 40 μmol for samples A to C.

As is apparent from the above, the titanium oxide particulates of the invention have a high photocatalytic activity and a high acetic acid decomposing activity on account of another reason which, unlike in conventional titanium oxide particulates, is not attributable to differences in adsorbing ability owing to the size of the specific surface, namely, on account of a high crystallinity.

Furthermore, the titanium oxide particulates of the invention can, if desired, be doped with other elements, including elements such as phosphorus, nitrogen, silicon and boron, thereby enabling adjustments to be made in the photocatalytic activity and enabling modifications in characteristics, such as a shift in the photocatalytic activity excitation light wavelength toward the long wavelength side. For example, in the particulate titanium oxide indicated as sample D in FIG. 3, silicon was added as a dopant to lower the photocatalytic activity of the particles.

Production of Particulate Titanium Oxide:

The inventive method and apparatus for manufacturing particulate titanium oxide are described in detail below.

The manufacture of the box-shaped polyhedral particles of titanium oxide according to the invention is basically carried out by feeding a titanium compound vapor and oxygen into a reaction tube and applying heat from outside the tube.

FIG. 4 shows an example of the inventive apparatus for manufacturing particulate titanium oxide. The apparatus includes a reaction tube 11 which is in the form of a pipe, has an inside diameter of 10 to 200 mm, and is made of a thermally and chemically stable material such as silica glass or alumina. At an inside diameter of less than 10 mm, the flow rate of raw materials within the reaction tube 11 becomes rapid, lowering the reaction efficiency. On the other hand, at an inside diameter of more than 200 mm, the reaction tube 11 has a large temperature distribution in the radial direction thereof, which increases the particle size distribution of the resulting titanium oxide particulates.

This reaction tube 11 is secured at both ends to a glass shaping lathe (not shown) and made to rotate at a speed of about 20 to 70 rpm. An oxyhydrogen flame burner 12 is situated below the reaction tube 11 so as to enable the tube 11 to be heated from the outside. One or more oxyhydrogen flame burner 12 may be used, although generally arranging about 4 to 12 such burners in a row is preferable for uniformly heating the reaction tube 11 and thereby achieving a small particle size distribution.

In heating with this burner 12, it is preferable for the size of the flame, the gap between the tube 11 and the burner 12, and other parameters to be controlled in such a way that at least one-third of the outer periphery of the tubular furnace 11 comes into contact with the flame. Such control is also helpful for uniform heating.

The apparatus shown in FIG. 4 also includes a bubbler 13. The interior of the bubbler 13 is filled with a titanium compound such as titanium tetrachloride or titanium sulfate in the form of a liquid. A gas such as argon supplied by a line 14 is blown into the titanium compound liquid (bubbling), thereby vaporizing the titanium compound. The temperature of the titanium compound liquid at this time, if the titanium compound is titanium tetrachloride for example, is set, based on the size of the vapor pressure, to at least 60°C. The resulting titanium compound vapor is introduced to the interior of the reaction tube 11 from one end thereof through a line 15 held to at least the temperature of the bubbler 13, e.g., to at least 85°C in the case of titanium tetrachloride, so that the gasified titanium compound vapor does not liquefy.

In addition, oxygen from an oxygen supply source such as an oxygen cylinder (not shown) is introduced through a line 16 from one end of the reaction tube 11.

The other end of the reaction tube 11 has one end of a line 17 connected thereto, with the other end of this line 17 being connected to a bag filter 18 so as to deliver exhaust from the reaction tube 11 to the bag filter 18.

This bag filter 18 traps some or all of the titanium oxide particulates which are synthesized in the tube 11 and flow out of the tube 11 with the exhaust. Use is also made of a mechanism which employs compressed gas such as air or nitrogen to apply an impact to the filter 18 in order to knock off titanium oxide particles clogging the filter 18, or a mechanism which mechanically knocks down such particles.

Exhaust from the bag filter 18 is discharged outside of the system by an exhaust unit (not shown).

The method for manufacturing titanium oxide particulates using this apparatus is explained.

First, the titanium compound vapor from the bubbler 13 and the oxygen from the oxygen supply source are introduced into the rotating reaction tube 11, heat is applied by an oxyhydrogen flame burner 12 from outside the tube 11, and a titanium compound such as titanium tetrachloride is thermally oxidized within the tube 11, thereby synthesizing titanium oxide particulates.

The temperature in the reaction zone within the reaction tube 11 during synthesis is set at 850 to 1500°C. At less than 850°C, the percent conversion declines, whereas at 850°C and above a percent conversion of 90% or higher is achieved. At above 1500°C, the particles of titanium oxide that have formed start to mutually sinter, lowering the specific surface area of the resulting titanium oxide particulate.

Concerning the flow rate of the titanium compound vapor and oxygen within the reaction tube 11, a more rapid flow rate shortens the time it takes for these to pass through the heat zone, i.e., the crystal growth time, enabling titanium oxide particulate of a small particle size to be obtained. However, if the flow rate is too rapid, the efficiency of the reaction greatly decreases, which is industrially undesirable. With titanium tetrachloride as the starting material, using a silica glass reaction tube 11 having an inside diameter of 32 mm and a thickness of 2.5 mm, and setting the synthesis temperature at 1230°C, a flow rate of 150 to 1500 mm/min is desirable.

An oxyhydrogen flame burner 12 is used as the heating source for synthesis, but this oxyhydrogen flame burner generates a large amount of heat and is more capable of localized heating than an electric heater. Hence, the heat energy required for uniform nucleus formation can easily be obtained, in addition to which the heat zone is narrower, enabling crystal growth of the titanium oxide to be suppressed. Moreover, the elevated temperatures required for diffusive movement of the atoms can be obtained, making it possible to synthesize highly crystalline titanium oxide particulates.

The ratio in which the titanium compound vapor and the oxygen are supplied to the interior of the reaction tube 11 is set based on the stoichiometry of the oxidation reaction, although it is preferable for the oxygen to be supplied in a slight excess so that the oxidation reaction proceeds to completion. For example, when titanium tetrachloride is used as the titanium compound, it is desirable for about 1.05 to 1.2 moles of oxygen to be used per mole of the titanium tetrachloride.

The titanium oxide particulates synthesized within the reaction tube 11 are carried by the exhaust stream to the downstream side of the tube 11. However, the downstream side of the reaction tube 11 is not heated and so has a low temperature of several tens of degrees Centigrade. The high-temperature titanium oxide particulates are thus rapidly cooled and accumulate on the wall in the downstream portion of the reaction tube 11 due to a thermophoretic effect. Because the temperature in the synthesis portion is locally heated to about 1000°C and the downstream portion has a temperature of several tens of degrees Centigrade, such thermophoresis works effectively, resulting in efficient accumulation of the titanium oxide particulates.

When the downstream portion of the reaction tube 11 is cooled with water or a gas such as nitrogen, the efficiency of accumulation by titanium oxide particulates increases. In addition, when helium gas, which has a large thermal conductivity and a high heat transfer effect, is fed into the reaction tube 11, cooling in the downstream portion is carried out even more efficiently, further increasing the thermophoretic effect and thereby also improving the accumulation efficiency.

The remaining titanium oxide particulates present in the exhaust are carried by the stream into the bag filter 18, where they are collected. The synthesized titanium oxide particulate is composed of very small particles which tend to clog the filter during collection. For this reason, a bag filter equipped with a mechanism that applies an impact to the filter with compressed gas such as air or nitrogen to knock off titanium oxide particles clogging the filter or a mechanism that mechanically knocks down such particles is desirable for dealing with clogging.

Also, at the time of this synthesis reaction, by adjusting the reaction conditions such as the raw material concentrations and the reaction temperature, the rate of crystal growth at each crystal face of the single crystalline polyhedron can be varied, enabling the flatness ratio to be controlled. The number of faces on the polyhedron can also be controlled. Moreover, titanium oxide particulates which are in the form of single crystalline polyhedrons having a flatness ratio of 0.33 to 3.0, and preferably 0.6 to 1.67, and which have a very high photocatalytic effect can be produced.

Furthermore, by having the reaction atmosphere be an oxidizing atmosphere, the proportion of particles with an anatase-type crystal structure can be set to at least 95%. The relative proportions of anatase and rutile can be controlled by suitably changing the reaction atmosphere from an oxidizing atmosphere to a reducing atmosphere.

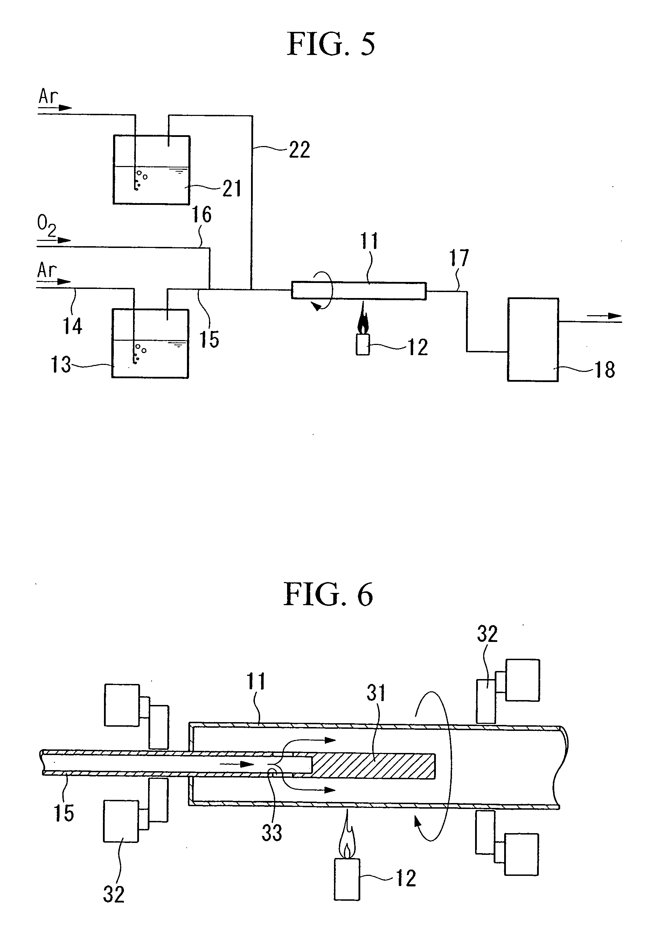

FIG. 5 shows another embodiment of the inventive apparatus for manufacturing titanium oxide particulates. Like elements with those of the apparatus shown in FIG. 4 are labeled with the same reference symbols and explanations of those elements are omitted here.

The manufacturing apparatus according to this embodiment can be used when a dopant such as phosphorus, nitrogen, silicon or boron is added to the particulate titanium oxide being synthesized, and has an additional bubbler 21 that generates a chemical vapor for supplying a dopant. The dopant-supplying chemical vapor from this bubbler 21 passes through a line 22 and joins the stream in line 15, after which it is enters the reaction tube 11.

Alternatively, the dopant-supplying chemical vapor may be fed by connecting the line 22 directly to the reaction tube 11 and feeding the chemical vapor directly into the tube 11. Nor is the heating source limited to an oxyhydrogen flame burner. For example, localized heating can be carried out using an electric heater. However, an oxyhydrogen flame burner is preferred for the reasons given above.

Recovery of the resulting titanium oxide particulates may simply involve accumulation in the downstream portion of the reaction tube using the thermophoretic effect. However, it is also possible to send the titanium oxide particulates that have formed directly to the bag filter 18 and collect them there without first allowing the particles to accumulate. Alternatively, the titanium compound raw material can be rendered into a titanium compound vapor by a method that involves heating to vaporize (baking).

The above-described box-shaped polyhedral titanium oxide particulates can be efficiently manufactured using the foregoing type of method. Although this manufacturing process is classed as a thermal oxidation process, prior-art thermal oxidation processes in which titanium tetrachloride vapor and heated oxygen are introduced into a reaction chamber and subjected to an oxidation reaction produce only spherical titanium oxide particles and can provide only large size particles.

By contrast, the above-described production process can provide particulate titanium oxide having an average particle size of 20 nm and a particle size distribution in which particles with a diameter of 10 to 40 nm account for 85% of all the particles.

FIG. 6 shows another embodiment of the particulate titanium oxide manufacturing apparatus of the invention. Aside from having a cylindrical member 21 provided at a heating site at the interior of the reaction tube 11, the manufacturing apparatus in this embodiment is identical with that shown in FIG. 4.

This cylindrical member 31 is in the form of a hollow round cylinder that is closed on one end or in the form of a solid round rod. It is made of a material such as silica having a coefficient of thermal expansion which is the same as or similar to that of the material making up the reaction tube 11. As shown in the diagram, this cylindrical member 31 is disposed away from the inside wall of the reaction tube 11 and coaxial with the reaction tube 11. The gap between this member 31 and the face of the inside wall is from 0.1 to 10 mm. At a gap of less than 0.1 mm, the particles that form will obstruct this gap, whereas at a gap of more than 10 mm, the zone having a non-uniform temperature distribution increases, making it pointless to provide the cylindrical member 21.

The cylindrical member 31 in this embodiment is supported by joining it to a front end of the raw material gas supply line 15, and the line 15 is rotatably supported by a glass shaping lathe 32. Raw material gas from the line 15 is introduced to the interior of the reaction tube 11 through holes 33 formed at the front end of the line 15.

A method of manufacturing particulate titanium oxide using the manufacturing apparatus of this embodiment is described. By providing such a cylindrical member 31, the raw material gas introduced into the reaction tube 11 is guided to the inner wall side of the tube 11 and flows along this inside wall. Moreover, because the inside wall portion of the tube 11 is heated to the highest temperature by the oxyhydrogen flame burner 12, the raw material gas is heated in the high heating temperature zone within the tube 11, causing the oxidation reaction to proceed. As a result, the titanium oxide particulates thus formed have a uniform particle size. Moreover, a large number of highly crystalline particles can be obtained and the variation in crystal shape is reduced. These effects in turn make it possible to produce particulate titanium oxide of a high catalytic activity. Using this manufacturing apparatus, for example, particulate titanium oxide can be obtained which has an average particle size of 20 nm and a particle size distribution such that particles having a diameter of 10 to 40 nm account for 85% of all the particles.

Concerning the production conditions in this manufacturing process, a more rapid flow rate for the raw material gas shortens the time required for the gas to pass through the heating zone and results in the formation of smaller size titanium oxide particles, but lowers the reaction efficiency. Accordingly, assuming the reaction tube 11 has an inside diameter of 36 mm, the cylindrical member 31 has an outside diameter of 20 mm and the synthesis temperature is 1100°C, it is preferable for the flow rate of the raw material gas to be set at about 150 to 1500 mm/min.

Applications for the Particulate Titanium Oxide:

Various applications in which the above-described particulate titanium oxide have been used are described below.

Photocatalyst:

The photocatalyst of the invention is composed of the above-described box-shaped polyhedral titanium oxide particles or a titanium oxide powder which is an aggregate of numerous such titanium oxide particles. This titanium oxide particulate or powder, when applied and made to adhere to a substrate by a suitable means, exhibits a photocatalytic effect. For example, by dispersing the titanium oxide particulate or powder in a dispersing medium such as an organic solvent to form a paste, applying the paste to a substrate (e.g., glass, ceramic, metal, wood, plastic, or a paint film) and heating so as to support the particulate or powder on the substrate, the titanium oxide particulate or powder will function as a photocatalyst. Alternatively, by adding a binder such as low-melting glass or any of various types of polymer, then applying the resulting mixture onto the substrate and heating so that the binder melts and sticks to the substrate, the titanium oxide particulate or powder will function as a photocatalyst.

The photocatalyst of the invention can also be prepared in a form that is responsive to visible light. For example, the titanium oxide particulate of the invention may be heated for a given length of time in an ammonia gas atmosphere diluted to a given concentration with argon to form a visible light-responsive photocatalyst. Visible light-responsive photocatalysts exhibit photocatalytic activity even under visible light having a wavelength of 400 nm or more, and so full use can be made of their photocatalytic activity even with exposure to visible light from artificial light sources, including indoor and other fluorescent lights, and electric lights.

These photocatalysts can be employed in the same way as photocatalysts composed of prior-art particulate titanium oxide for such purposes as to decompose and eliminate contaminants, decompose and eliminate malodorous substances, sterilize or disinfect, and also to form a super-water-repellent film or to prevent surface staining. The specific forms in which the inventive photocatalysts are used may be the same as those in which photocatalysts composed of prior-art particulate titanium oxides are used.

Coatings:

The coatings of the invention contain as essential ingredients the above-described particulate titanium oxide or titanium oxide powder, and film-forming resin ingredients.

The amount of particulate titanium oxide formulated in such a photocatalytic coating is set within a range of 0.1 to 80 wt%, and preferably 5 to 20 wt%, based on the total solids. If the amount of particulate titanium oxide included in the coating is lower than this range, the resulting film may not exhibit a sufficient photocatalytic activity. On the other hand, if the amount of particulate titanium oxide in the coating exceeds the above range, the coating may have a poor flow, making it difficult to apply, and the lower level of resin ingredients may make it impossible to obtain a tough film.

The resin ingredient included in this coating is not subject to any particular limitation, insofar as the coating is capable of forming a good film. For example, suitable use may be made of such resin ingredients hitherto employed in connection with coatings as acrylic resins, alkyd resins or polyurethane resins. These resins can be used as an aqueous emulsion having a resin content of 10 to 40 wt%. If an aqueous emulsion is used, there is no need to include a solvent, and the coating is harmless in a natural environment.

The resin ingredient is included in an amount, based on the total solids, within a range of 20 to 99.9 wt%, and preferably 50 to 80 wt%.

Any solvent suitable for dissolving the resin ingredient used may be employed as the solvent in this coating. Illustrative examples of appropriate solvents include water, hydrocarbon solvents such as ethanol, aromatic hydrocarbons and cyclic hydrocarbons, ketones such as acetone, and esters such as ethyl acetate. The solvent is included in an amount, per 100 parts by weight of the total solids in the photocatalytic coating, of about 80 to 99.5 wt%.

In addition to the above essential ingredients, the coating may also include therein optional additives such as pigments, dispersion stabilizers, ultraviolet absorbers and antioxidants, provided such addition does not compromise the physical properties or photocatalytic activity of the coating.

This coating, when applied onto a substrate such as a metal plate, ceramic plate (e.g., tile), glass, wood or concrete, then dried and solidified, can form a film having a photocatalytic activity. The method of applying the photocatalytic coating onto a substrate can be suitably selected from among various coating methods known to the art, based on such considerations as the shape, material and size of the substrate. Specific coating methods that may be used include, for example, dip coating, brush coating, spray coating, electrodeposition, spin coating, and doctor blade coating.

Because this coating includes particulate titanium oxide having a high photocatalytic activity, a film having a higher photocatalytic activity than conventional product can be formed by applying the coating to a suitable substrate.

It should be noted that when the particulate titanium oxide in this coating has a high photocatalytic activity, certain ingredients within the coating, such as the resin ingredient and the solvent, may themselves be degraded. Accordingly, it may be desirable in some cases to use particulate titanium oxide in which the photocatalytic activity has been lowered somewhat by the addition of an element such as silicon.

Photocatalytic Device:

The photocatalytic device of the invention includes a photocatalytic reactant having on a surface thereof particulate titanium oxide particles, and a light source which directs light at the photocatalytic reactant.

No limitation is imposed on the shape and structure of the photocatalytic reactant. For example, this may be in the form of a powder or in the form of a suspension within a liquid such as water, although a structure obtained by applying a coating that contains the above-described particulate titanium oxide or titanium oxide powder to the surface of a suitable substrate is preferred.

This structure may have any of various shapes, such as a plate-like, tubular, honeycomb or particulate shape. The shape is selected as appropriate for such considerations as the properties of the noxious substance-containing material to be treated and the method by which the material is to be fed to the photocatalytic device. A structure which is, for example, plate-like, tubular or honeycomb-shaped, can be manufactured by applying the above-described coating to the surface of a metal plate, metal tube or metal honeycomb material. Alternatively, a particulate structure can be manufactured by applying the above-described coating to particles having a suitable particle size, such as glass beads, synthetic resin beads or porous ceramic.

The light source used in this photocatalytic device is preferably an artificial light source such as a high-pressure mercury vapor lamp, xenon lamp or black light.

The construction of this photocatalytic device may be varied as appropriate for the properties of the noxious substance-containing material to be treated and the method by which the material will be fed to the device. For example, if the material to be treated is a liquid such as industrial wastewater, by using an arrangement in which the above-described photocatalytic reactant in, for example, a plate-like, tubular, honeycomb-shaped or particulate form is placed within a tank and the light source is located within the tank or the interior of the tank is irradiated with light from a source outside of the tank using optical fibers, the liquid to be treated can be placed in the tank and the noxious substance decomposed by the photocatalytic reactant.

If the material to be treated is a gas such as an exhaust gas, the photocatalytic reactant and light source described above may be placed in the flow path of the gas to be treated and this gas brought into contact with the photocatalytic reactant to effect decomposition of the noxious substance. Alternatively, the interior of a tank having a light source disposed therein may be filled with the above-described particulate photocatalytic reactor and the gas to be treated blown in from underneath the tank so as to form a fluidized bed of the photocatalytic reactant in which the gas is treated.

The photocatalytic device of the invention, by virtue of a construction which includes both a photocatalytic reactant bearing the above-described particulate titanium oxide on the surface and also a light source that shines light onto this photocatalytic reactor, can very efficiently decompose noxious substances such as nitrogen oxides, contaminants and malodorous ingredients.

Method of Decomposing Noxious Substances:

The inventive method of decomposing noxious substances using a titanium oxide powder employs a powder which is an aggregate of titanium oxide particles having a particle size of 100 to 500 nm, in which at least 90% of all the particles making up the powder are composed of anatase-type crystals, and in which the particles of titanium oxide are polyhedra such as box-shaped decahedra. This method involves directly contacting the titanium oxide powder with a fluid such as water or air in which the noxious substance is dissolved or dispersed, irradiating the resulting system with light such as ultraviolet light so as to decompose the noxious substances within the fluid, then filtering the fluid with a filter so as to separate off and recover the titanium oxide powder.

Particulate titanium oxide having a high photocatalytic activity generally has a small particle diameter. Hence, particulate titanium oxide with a particle diameter ranging from several nanometers to several tens of nanometers is used in such applications. However, when particles of such a size are used and dispersed in a medium such as water, they agglomerate, forming clusters about 300 nm in size. Clusters of this size are filtered using a filter having a pore size of about 0.1 μm, but such fine filters readily clog, which is impractical.

By contrast, when the particulate titanium oxide of the invention is employed, even if a particulate having a large particle size of 100 to 500 nm is selected and used, owing to its inherently high crystallinity, this particulate has a good catalytic activity and thus exhibits a high decomposing ability. Moreover, because agglomerated clusters of such particles have a size of about 2 to 5 μm, filtration can be rapidly carried out using a filter having a pore size of 1 to 2 μm and the filter does not readily clog, making the inventive particulate highly practical.

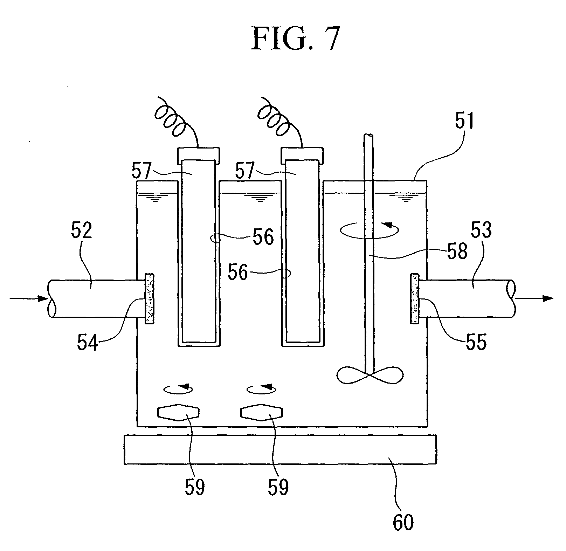

FIG. 7 shows an example of a treatment apparatus that can be used in the inventive method of decomposing noxious substances. The target of treatment by this apparatus is a liquid composed of the noxious substance dissolved or dispersed in water.

The apparatus shown in the diagram includes a treatment tank 51 made of a suitable material such as stainless steel or plastic. Connected to this treatment tank 51 are an inlet line 52 for the inflow of liquid to be treated and a discharge line 53 for the outflow of liquid following decomposition treatment. A pre-filter 54 is provided at the front end of the inlet line 52 to remove coarse debris dispersed in the inflowing liquid. A solid/liquid separation filter 55 is provided at the tank end of the discharge line 53 to filter off, and thereby separate and recover, the titanium oxide powder dispersed in the liquid being treated. The separation filter 55 is a filter made of a suitable material such as glass fibers.

Recesses 56 for receiving and holding ultraviolet lamps are formed at the top of the treatment tank 51. The walls of the recesses 56 are made of an ultraviolet light-transmitting glass such as silica and serve as irradiation windows. Ultraviolet light from ultraviolet light sources 57 such as high-pressure mercury vapor lamps, xenon lamps, germicidal lamps or black lights held in the recesses 56 is directed through the irradiation windows at the liquid to be treated within the treatment tank 51. The titanium oxide particles dispersed in the treatment liquid exhibit photocatalytic effects on account of this ultraviolet light, thereby decomposing and rendering innocuous the noxious substance dissolved or dispersed in the treatment liquid.

Moreover, a propeller shaft 58 and magnetic stirring bars 59 are provided in the treatment tank 51 to stir the treatment liquid within the tank. The magnetic stirring bars 59 are rotated by a magnet stirrer 60 situated below the treatment tank 51.

If the particulate titanium oxide used is of a visible light-responsive type which exhibits activity upon exposure to visible light such as sunlight, part or all of the treatment tank 51 may be made of a suitable material such as glass.

In a treatment method which uses this treatment apparatus, the dispersion concentration of titanium oxide particles within the treatment liquid is typically set at from 0.5 to 10 wt%. At less than 0.5 wt%, decomposition does not fully proceed, whereas at more than 10 wt%, uniform dispersion of the particles is difficult and the titanium oxide particles have a tendency to settle while holding on to the noxious substance.

As decomposition treatment proceeds, the particles of titanium oxide are captured by the separation filter 55, and the concentration of such particles dispersed within the treatment liquid decreases. By carrying out a common back-washing operation at this time, the separator filter 55 is freed of clogging and the dispersed concentration of titanium oxide particles within the treatment liquid is restored.

In a decomposition method such as this, because the particles of titanium oxide agglomerate within the treatment liquid, forming clusters at least 2 μm in size, filtration can be carried out efficiently and at a high speed using a relatively coarse solid/liquid separation filter 55 having a pore size of at least 1 μm. For example, a filtration rate of 10 liters or more per hour can be achieved with a glass-fiber filter having an effective surface area of 500 cm$^2$ and a pore size of 2 μm.

If the noxious substance is dissolved or dispersed within a gas such as air, use can be made of a method wherein this gas is introduced into the treatment tank and stirred with a fan provided inside the treatment tank. At the same time, the titanium oxide powder is forcibly suspended and thereby dispersed, and is irradiated in this state with light such as ultraviolet light. Alternatively, use can be made of a method wherein a fluid containing the noxious substance in dissolved or dispersed form is contacted with a film that has been formed by applying the above-described coating to the surface of a suitable substrate, and is irradiated with light.

Examples of noxious substances which may be decomposed by the inventive method of decomposing noxious substances include nitrogen oxides (NOx), contaminants, and malodorous ingredients. Specific examples of contaminants and malodorous ingredients include aldehydes such as acetaldehyde, alcohols such as butyl alcohol, carboxylic acids such as acetic acid, ketones, nitrogen-containing compounds such as ammonia and amines, and sulfur-containing compounds such as hydrogen sulfide and mercaptan.

By bringing such noxious substances into contact with particulate titanium oxide while irradiating the system with light according to the inventive method of decomposing noxious substances, noxious substances such as nitrogen oxides (NOx), it is possible to very efficiently decompose contaminants and malodorous ingredients.

The invention is illustrated more fully in the following examples.

Comparative Example 1:

Titanium tetrachloride vapor as the raw material was mixed with heated and temperature-regulated oxygen within a reaction chamber, thereby effecting thermal oxidation and synthesizing titanium oxide particles. The titanium tetrachloride vapor was fed by bubbling, and the bubbler temperature was set at 85°C. Argon was used as the bubbling gas, and the flow rate was set at 200 sccm. The oxygen used for the reaction was set to a flow rate of 1,000 sccm and a temperature of 1000°C. The resulting titanium oxide particles had a spherical shape, an average particle size of 90 nm, and the particle size distribution was such that particles having a diameter of at least 20 nm but not more than 200 nm accounted for 85% of all the particles.

Example 1:

Particulate titanium oxide was produced by a thermal oxidation process in which a reaction tube made of silica glass was used, oxyhydrogen burners were used as the heat source, titanium tetrachloride vapor and oxygen were introduced to the reaction tube, and heat was applied from outside the tube. The titanium tetrachloride vapor was fed with a bubbler, the bubbler temperature was set at 85°C, and the gas lines were held at a temperature of 140°C. Argon was used as the bubbling gas, and its flow rate was set at 180 sccm. The oxygen used as the reactant was set to a flow rate of 1,000 sccm, and the reaction temperature was set at 1230°C. Six oxyhydrogen flame burners were installed. The silica glass tube had an inside diameter of 32 mm and a wall thickness of 2.5 mm, and was rotated at a speed of 55 rpm.

The particles of titanium oxide thus obtained were in the shape of decahedrons like that shown in FIG. 1. The average particle size was 20 nm, and the particle size distribution was such that particles having a diameter of at least 10 nm but not more than 40 nm accounted for 85% of all the particles. The flatness ratio was 0.33 to 3.0.

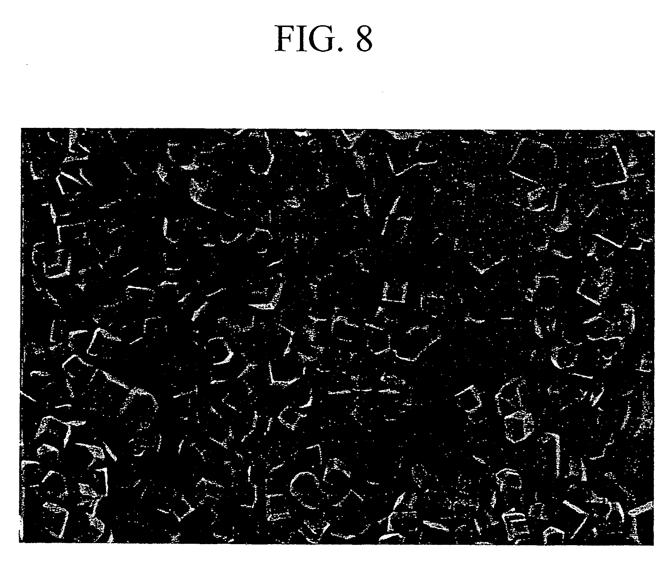

FIG. 8 is a scanning electron micrograph showing an example of the shape of titanium oxide particles produced under these manufacturing conditions.

In addition, the proportion of titanium oxide particles having an anatase-type crystal structure, as determined from peak intensities in x-ray diffractometry, was 95%.

Next, this particulate titanium oxide was heat treated in a nitrogen atmosphere at 500°C for 24 hours. The heat-treated particulate titanium oxide was subjected to x-ray diffractometry and electron microscopy. Electron microscopic examination showed that particle sintering had not progressed, and necking between the particles was not observed. The percentage of the titanium oxide particles having an anatase-type crystal structure was determined from the peak intensities obtained in x-ray diffractometry. The percentage of all particles accounted for by titanium oxide particles having an anatase-type crystal structure remained unchanged from that prior to heat treatment.

This particulate titanium oxide was also heat treated in a nitrogen atmosphere at 700°C for 24 hours. The heat-treated particulate titanium oxide was subjected to x-ray diffractometry and electron microscopy. Electron microscopic examination showed that particle sintering had not progressed, and necking between the particles was not observed.

The percentage of titanium oxide particles having an anatase-type crystal structure was determined from the peak intensity obtained in x-ray diffraction analysis. The proportion of all particles accounted for by titanium oxide particles having an anatase crystal structure decreased slightly relative to before heat treatment, but the rutile transition ratio R(700-24) was 5.0%.

Example 2:

The particulate titanium oxide obtained in Example 1 was coated onto a silica glass plate and the photocatalytic activity when irradiated with ultraviolet light was evaluated.

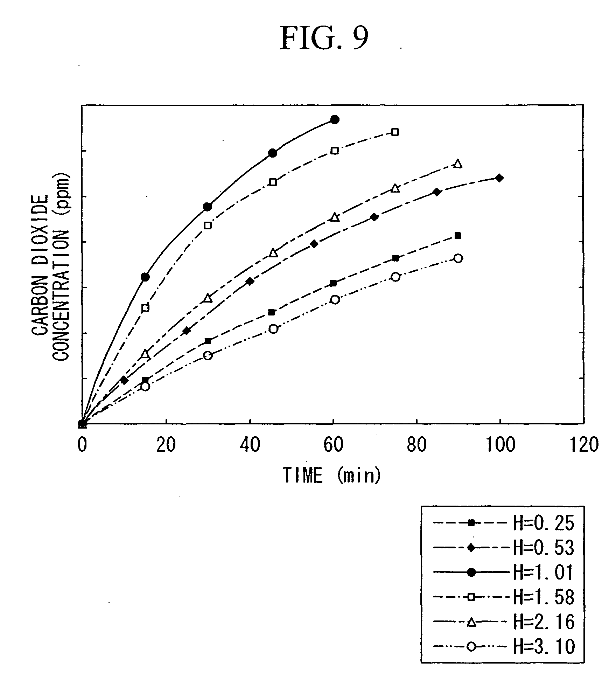

Evaluation was carried out based on the ability of the particulate titanium oxide to decompose acetaldehyde under identical conditions. The concentration of carbon dioxide generated by such decomposition was measured, and the relationship of this concentration with the flatness ratio H of the polyhedrons making up the particulate titanium oxide was determined. FIG. 9 shows the change over time in the carbon dioxide concentration at titanium oxide catalysts having various flatness ratios. Those samples in which the polyhedrons had a flatness ratio of 1.01 or 1.58 had the highest activities, and those samples in which the flatness ratio was 0.53 or 2.16 had the next highest activities.

Comparative Example 2:

The particulate titanium oxide obtained in Comparative Example 1 was coated onto a silica glass plate, following which *Escherichia coli* bacteria were applied. The glass plate was then irradiated with a black light and the change over time in the number of bacteria was studied. The results showed that it took 60 minutes for the number of bacteria to fall below 1% of the initial number.

Example 3:

The particulate titanium oxide obtained in Example 1 was coated onto a silica glass plate, following which *E. coli* bacteria were applied. The glass plate was then irradiated with a black light and the change over time in the number of bacteria was studied. The results showed that it took 30 minutes for the number of bacteria to fall below 1% of the initial number.

Example 4:

Particulate titanium oxide was produced by a thermal oxidation process in which a reaction tube made of silica glass was used, oxyhydrogen burners were used as the heat source, titanium tetrachloride vapor and oxygen were introduced to the reaction tube, and heat was applied from outside the tube. The titanium tetrachloride vapor was fed with a bubbler, and the bubbler temperature was set at 85°C. Argon was used as the bubbling gas, and its flow rate was set at 180 sccm.

The oxygen used as a reactant was set to a flow rate of 1,000 sccm, and the reaction temperature was set at 1230°C. The silica glass tube had an inside diameter of 32 mm and a wall thickness of 2.5 mm, and was rotated at a speed of 55 rpm.

The synthesized particulate titanium oxide was subjected to x-ray diffractometry and electron microscopy. Electron microscopic examination showed that the particles had a decahedral shape, the average particle size of the particulate titanium oxide was 60 nm, and the particle size distribution was such that particles having a diameter of 20 to 100 nm accounted for 85% of all the particles. The percentage of titanium oxide particles having an anatase-type crystal structure was determined from the peak intensities obtained in x-ray diffractometry. The results are shown in Table 1.

Next, the particulate titanium oxide was heat treated in a nitrogen atmosphere at 500°C for 24 hours. The heat-treated particulate titanium oxide was subjected to x-ray diffractometry and electron microscopy. Electron microscopic examination showed that particle sintering had not progressed, and necking between the particles was not observed. The percentage of titanium oxide particles having an anatase-type crystal structure was determined from the peak intensities obtained in x-ray diffractometry. The results are shown in Table 1. The proportion of all particles accounted for by titanium oxide particles having an anatase-type crystal structure remained unchanged from that prior to heat treatment.

This particulate titanium oxide was also heat treated in a nitrogen atmosphere at 700°C for 24 hours. The heat-treated particulate titanium oxide particles was subjected to x-ray diffractometry and electron microscopy. Electron microscopic examination showed that particle sintering had not progressed, and necking between the particles was not observed.

The percentage of titanium oxide particles having an anatase-type crystal structure was determined from the peak intensities obtained in x-ray diffractometry. The results are shown in Table 1. The proportion of all particles accounted for by titanium oxide particles having an anatase-type crystal structure decreased slightly relative to before heat treatment, but the rutile transition ratio R(700-24) was 4.2%.

Comparative Example 3:

Commercial particulate titanium oxide for photocatalytic use was purchased and compared. The titanium oxide particulates used for the sake of comparison were particles synthesized by a thermal hydrolysis process. Electron microscopic examination showed that the particles were spherical, had an average diameter of 60 nm, and had a particle size distribution such that particles with a diameter of 10 to 100 nm accounted for 85% of all the particles. The percentage of titanium oxide particles having an anatase-type crystal structure was determined from the peak intensities obtained in x-ray diffractometry. The results are shown in Table 1.

Next, this particulate titanium oxide was heat treated in a nitrogen atmosphere at 700°C for 24 hours. The heat-treated particulate titanium oxide was subjected to x-ray diffractometry and electron microscopy. Electron microscopic examination showed that particle sintering had not progressed, and necking between the particles was not observed.

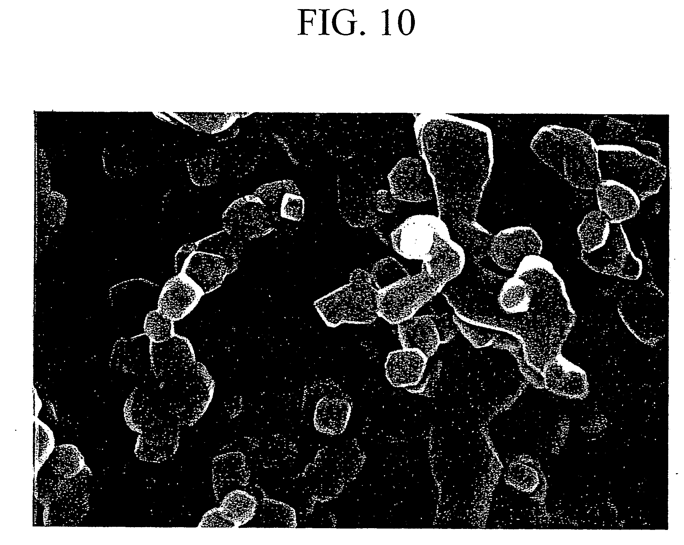

FIG. 10 shows an electron micrograph of these particles after they have been heated.

The percentage of titanium oxide particles having an anatase-type crystal structure was determined from the peak intensities obtained in x-ray diffractometry. The results are shown in Table 1. The proportion of all particles accounted for by titanium oxide particles having an anatase-type crystal structure decreased markedly relative to before heat treatment. Specifically, the rutile transition ratio R(700-24) was 78.5%.

Table 1

| | Proportion of anatase before heat treatment (%) | Proportion of anatase after heat treatment 500°C, 24 hours (%) | Proportion of anatase after heat treatment 700°C, 24 hours (%) | Rutile transition ratio (%) R (500-24) | Rutile transition ratio (%) R (700-24) |
|---|---|---|---|---|---|
| Example 4 | 95.0 | 95.0 | 91.0 | 0.0 | 4.2 |
| Comparative Example 3 | 70.0 | - | 15.0 | - | 78.5 |

Example 5:

The particulate titanium oxide produced in Example 4 was mixed with low-melting glass, a binder and a solvent to form a titanium oxide slurry. This slurry was applied uniformly to a silica glass plate, then fired by heating in air at 700°C for 2 hours, thereby giving a glass plate which supports particulate titanium oxide. The photocatalytic activity of this glass plate upon irradiation with ultraviolet light was evaluated in terms of the ability of the plate to decompose acetaldehyde by measuring the concentration of carbon dioxide that evolves from decomposition.

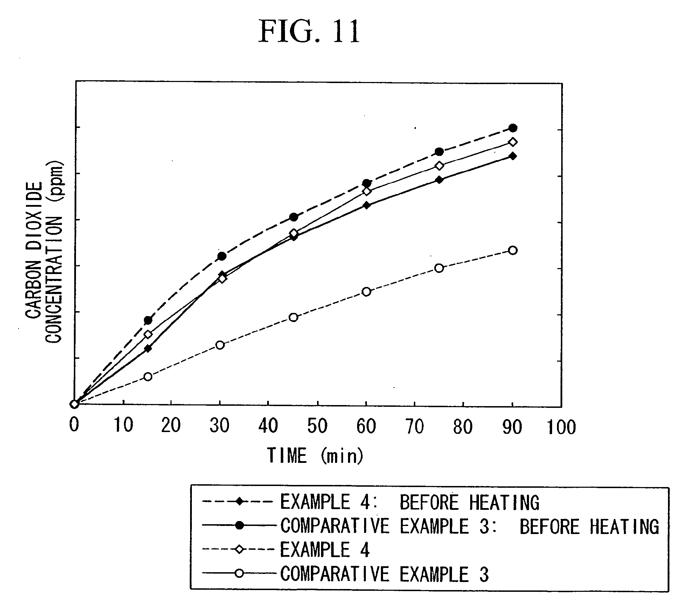

For the sake of comparison, a similar particulate titanium oxide-supporting glass plate was manufactured using the particulate titanium oxide of Comparative Example 3 (commercial product). FIG. 11 shows the change over time in the carbon dioxide concentration. FIG. 11 also shows the results obtained when the same experiment was carried out after slurry application and before firing (no heat treatment).

From these results, it is evident that the glass plate fabricated using the commercial particulate titanium oxide used for comparison experienced a large decline in activity after firing as opposed to before firing, whereas the glass plate fabricated using the particulate titanium oxide of Example 4 exhibited a strong ability to decompose acetaldehyde with no change in characteristics.

Example 6:

Particulate titanium oxide was manufactured using the particulate titanium oxide manufacturing apparatus shown in FIG. 4. A reaction tube made of silica glass and having an outside diameter of 40 mm was mounted on a glass shaping lathe and rotated at 45 rpm. Titanium tetrachloride vapor (50 sccm) and oxygen (1,200 sccm) were introduced to this tube, which was heated from the outside with an oxyhydrogen burner flame at 1300°, thereby synthesizing particulate titanium oxide within the tube. The resulting titanium oxide particulates were recovered with a bag filter.

The recovered titanium oxide particles were decahedrons. Identification based the x-ray diffractometry (XRD) peaks showed that 96% of all the particles in the powder were anatase-type crystals. The specific surface area, as measured by the BET method, was 10.2 $m^2$/g.

When 50 mg of the resulting particulate titanium oxide was placed in a sealed container having an inside diameter of 15 mm, suspended in 5 ml of a 5% by volume aqueous solution of acetic acid and, in the suspended state, irradiated with 365 nm ultraviolet light at an exposure dose of 15 mW/$cm^2$, the rate of carbon dioxide evolution per hour was quantitatively analyzed and found to be 54 μmol.

Example 7:

A reaction tube made of silica glass and having an outside diameter of 40 mm was mounted on a glass shaping lathe and rotated at 45 rpm. Titanium tetrachloride vapor (20 sccm) and oxygen (1,200 sccm) were introduced to this tube, which was heated from the outside with an oxyhydrogen burner flame at 1300°, thereby synthesizing particulate titanium oxide within the tube. The particulate titanium oxide thus formed was recovered with a bag filter.

The recovered titanium oxide particles were decahedrons. Identification based on the x-ray diffractometry (XRD) peaks showed that 96% of all the particles in the powder were anatase-type crystals. The specific surface area, as measured by the BET method, was 32.4 $m^2$/g.

When 50 mg of the resulting particulate titanium oxide was placed in a sealed container having an inside diameter of 15 mm, suspended in 5 ml of a 5% by volume aqueous solution of acetic acid and, in the suspended state, irradiated with 365 nm ultraviolet light at an exposure dose of 15 mW/$cm^2$, the rate of carbon dioxide evolution per hour was quantitatively analyzed and found to be 52 μmol.

Example 8:

A reaction tube made of silica glass and having an outside diameter of 40 mm was mounted on a glass shaping lathe and rotated at 45 rpm. Titanium tetrachloride vapor (30 sccm) and oxygen (1,200 sccm) were introduced to this tube, which was heated from the outside with an oxyhydrogen burner flame at 1300°, thereby synthesizing particulate titanium oxide within the tube. The particulate titanium oxide thus formed was recovered with a bag filter.

The recovered titanium oxide particles were decahedrons. Identification based on the x-ray diffractometry (XRD) peaks showed that 96% of all the particles in the powder were anatase-type crystals. The specific surface area, as measured by the BET method, was 21.8 $m^2$/g.

When 50 mg of the resulting particulate titanium oxide was placed in a sealed container having an inside diameter of 15 mm, suspended in 5 ml of a 5% by volume aqueous solution of acetic acid and, in the suspended state, irradiated with 365 nm ultraviolet light at an exposure dose of 15 mW/$cm^2$, the rate of carbon dioxide evolution per hour was quantitatively analyzed and found to be 51 μmol.

Example 9:

A reaction tube made of silica glass and having an outside diameter of 40 mm was mounted on a glass shaping lathe and rotated at 45 rpm. Titanium tetrachloride vapor (40 sccm), silicon tetrachloride vapor (2 sccm) and oxygen (1,200 sccm) were introduced to this tube, which was heated from the outside with an oxyhydrogen burner flame at 1300°, thereby synthesizing particulate titanium oxide within the tube. The resulting titanium oxide particulates were recovered with a bag filter.

The recovered titanium oxide particles were decahedrons. Identification based on the x-ray diffractometry (XRD) peaks showed that 96% of all the particles in the powder were anatase-type crystals. The specific surface area, as measured by the BET method, was 30.1 $m^2$/g.

When 50 mg of the resulting particulate titanium oxide was placed in a sealed container having an inside diameter of 15 mm, suspended in 5 ml of a 5% by volume aqueous solution of acetic acid and, in the suspended state, irradiated with 365 nm ultraviolet light at an exposure dose of 15 mW/$cm^2$, the rate of carbon dioxide evolution per hour was quantitatively analyzed and found to be 36 μmol. It was thus possible by adding silicon to the raw material to intentionally control the ability of the synthesized particulate titanium oxide to catalyze decomposition.

Comparison of Prior-Art Products with Products According to the Invention:

Four types of commercial particulate titanium oxides (referred to below as commercial powders A to D) were acquired, each was subjected to x-ray diffraction analysis. The results of identification based on the diffractometry peaks indicated that all four types were titanium oxide powders having an anatase-type crystal content of at least 95%. The specific surface areas of these powders were measured by the BET method.

Fifty milligrams of these different particulate titanium oxide were separately placed in sealed containers having an inside diameter of 15 mm, suspended in 5 ml of a 5% by volume aqueous solution of acetic acid and, in the suspended state, irradiated with 365 nm ultraviolet light at an exposure dose of 15 mW/$cm^2$, and the rate of carbon dioxide evolution per hour was quantitatively analyzed. FIG. 3 shows plots of the resulting amounts of carbon dioxide on the y-axis versus their specific surface areas on the x-axis.

As shown in FIG. 3, when the specific surface area (x-axis) versus the rate of carbon dioxide evolution (y-axis) was plotted for each of commercial powders A to D (prior-art products), the characteristic values were either on or below the line represented by y = 0.8x. It is apparent from these results that, in the prior art, only particulates with characteristics positioned at or below this line could be produced.

On the other hand, the particulate titanium oxides of the invention represented in the table as Samples A to D had photocatalytic characteristics positioned substantially above this line. In a specific surface area range of 10 to 40 $m^2$/g, the rate of carbon dioxide evolution per hour was more than 40 μmol for samples A to C.

Moreover, the particulate titanium oxide represented as Sample D in FIG. 3 had a photocatalytic activity that was effectively lowered by the addition of silicon as a dopant.

Example 10:

Particulate titanium oxide was produced with the manufacturing apparatus shown in FIG. 6. Using a reaction tube made of silica glass and using oxyhydrogen burners as the heat source, particulate titanium oxide was manufactured by a thermal oxidation process in which titanium tetrachloride vapor and oxygen were introduced into the reaction tube and heat was applied from outside the tube. The titanium tetrachloride vapor was fed by bubbling, the bubbler temperature was set at 85°C, and the gas lines were held at a temperature of 140°C. Argon was used as the bubbling gas, and its flow rate was set at 200 sccm. The oxygen used as a reactant was set to a flow rate of 1,000 sccm, and the reaction temperature was set at 1100°C. The silica glass tube had an outside diameter of 40 mm and a wall thickness of 2 mm. The cylindrical member had an outside diameter of 20 mm, and the gap between the silica glass tube and the cylindrical member was set at 8 mm. This arrangement was rotated at a speed of 55 rpm.

The particles of titanium oxide thus obtained had a decahedral shape like that shown in FIG. 1, an average particle size of 20 nm, and a particle size distribution such that particles having a diameter of at least 10 nm but not more than 40 nm accounted for 85% of all the particles. The flatness ratio was 0.33 to 3.0.

X-ray diffractometry was carried out, and the percentage of titanium oxide particles having an anatase-type crystal structure was determined from the peak intensities to be 95%.

Example 11

The production conditions in Example 1 were changed and a titanium oxide powder was produced that had a particle size of 200 to 350 nm, a decahedral shape, and in which 97% of all the particles are anatase-type crystals.

A silica glass treatment tank was charged with 1.5 liters of an aqueous solution of 10 μmol/L methylene blue, following which 15 g of the above titanium oxide powder was added and the aqueous solution was stirred. This treatment tank was irradiated with ultraviolet light of 325 nm wavelength from a black light. The ultraviolet light receiving surface area of the treatment tank was 300 cm$^2$, and irradiation was carried out at an exposure dose of 2.5 mW/cm$^2$.

After 30 minutes, the tank contents were gravity filtered using a round cylindrical filter of glass fiber mesh having a surface area of 500 cm$^2$ and a pore size of 2.0 μm. It took 25 minutes to filter the entire amount. Following filtration, the filter was back-washed with water and the washings were dried, thereby recovering 13.5 g of titanium oxide powder, which was 90% of the amount initially charged.

The concentration of methylene blue in the filtered aqueous solution, as determined with a spectrophotometer, was 0.8 μmol/L. The solution appeared clear and colorless when observed directly with the unaided eye.

Comparative Example 4

A commercial titanium oxide powder was obtained for use. This powder had a particle size of 10 to 40 nm, a spherical particle shape, and 90% of all the particles were anatase-type crystals.

Using this commercial titanium oxide powder, decomposition was carried out on an aqueous solution of methylene blue under the same conditions as in Example 11.

However, in this case, filtration following treatment was carried out using a round cylindrical filter of glass fiber mesh having a surface area of 500 cm$^2$ and a pore size of 0.1 μm. Gravity filtration for 120 minutes resulted in the filtration of only 20 ml. Filtration was interrupted and backwashing carried out, after which filtration was attempted once again. However, because the titanium oxide particles had clogged the filter pores, the filtration rate did not improve.

The concentration of methylene blue in the filtered aqueous solution, as determined with a spectrophotometer, was 0.8 μmol/L. The solution appeared clear and colorless when observed directly with the unaided eye.

Comparative Example 5

A commercial photocatalyst composed of particulate titanium oxide supported on glass beads was prepared for use. This photocatalyst had a bead diameter of 1 mm and, when examined with an electron microscope, was found to have titanium oxide particles of 10 to 40 nm diameter adhering to the surface of the beads. When the crystal form of the titanium oxide particles was examined by x-ray diffractometry, although the peaks were broad due to the influence of the glass beads, the peaks for the anatase and for the rutile were found to have similar intensities.

Using 150 g of this photocatalyst, decomposition treatment was carried out on an aqueous solution of methylene blue under the same conditions as in Example 11.

After 30 minutes, the tank contents were gravity filtered using a round cylindrical filter of glass fiber mesh having a surface area of 500 cm$^2$ and a pore size of 2.0 μm. It took 15 minutes to filter the entire amount. Following filtration, the filter was back-washed with water, and the washings were dried, thereby recovering substantially all of the photocatalyst initially charged. However, some titanium oxide particles were found to have fallen from the glass beads, and so it was anticipated that the decomposition treatment ability will decline with reuse of the photocatalyst.

The concentration of methylene blue in the filtered aqueous solution, as determined with a spectrophotometer, was 4.6 μmol/L. The solution appeared clear and blue in color when observed directly with the unaided eye.

Example 12:

A treatment tank made of silica glass and having a capacity of 1.5 liters was constructed. The tank was equipped at the top with a shaft and attached propeller to enable agitation of the contents, and had a pump to enable the inflow and discharge of a fixed amount of aqueous solution. An inlet line and a discharge line were attached to the treatment tank. A pre-filter was mounted on the inlet line, and a round cylindrical solid/liquid separation filter of glass fiber mesh having a surface area of 500 cm$^2$ and a pore size of 2.0 μm was attached to the discharge line.

The treatment tank was filled with water and 15 g of the same titanium oxide powder as that used in Example 11 was added. An aqueous solution of 10 μmol/L methylene blue was introduced from the inlet line at a flow rate of 0.5 L/h, and the treated aqueous solution was made to flow out the discharge line.

The aqueous solution of methylene blue was run into the tank for a sufficient length of time. Once the methylene blue concentration of the solution flowing out the discharge line became the same as the concentration of the solution flowing into the tank, irradiation of the treatment tank interior with ultraviolet light having a wavelength of 365 nm from a black light was begun. The ultraviolet light-receiving surface area of the treatment tank was 300 cm$^2$; hence, irradiation occurred at an exposure dose of 2.5 mW/cm$^2$. To prevent clogging of the separation filter, the pump was stopped every 45 minutes, and 5 minutes of backwashing at a flow rate of 0.5 L/h was carried out by operating the pump in reverse.

The aqueous solution discharged from the discharge line was collected at fixed time intervals, and the methylene concentration was measured. One hour after the start of irradiation, the concentration stabilized at 3.6 μmol/L.

INDUSTRIAL APPLICABILITY

The particulate titanium oxide of the invention is well-suited for use in photocatalysts for such applications as the decomposition of noxious substances, deodorization and sterilization.

**Claims**

1. A particulate titanium oxide comprising particles which are each a box-shaped polyhedron composed of one or more single crystalline polyhedron, and which have a particle size of 1 to 500 nm.

2. The particulate titanium oxide of claim 1, wherein the single crystalline polyhedron has a flatness ratio of 0.33 to 3.0.

3. The particulate titanium oxide of claim 1, wherein the polyhedron has from six to ten faces.

4. The particulate titanium oxide of any one of claims 1 to 3 which has a rutile transition ratio R(700-24) of not more than 7.5% and a rutile transition ratio R(500-24) of not more than 2.0%.

5. The particulate titanium oxide of any one of claims 1 to 4, wherein the particle size is from 100 to 500 nm.

6. The particulate titanium oxide of any one of claims 1 to 5 which has a specific surface area of 3 to 40 m$^2$/g, and for which, when 5 ml of a 5% by volume aqueous solution of acetic acid and 50 mg of the particulate titanium oxide are placed in a sealed container having an inside diameter of 15 mm and, in a suspended state, are irradiated with 365 nm ultraviolet light at an exposure dose of 15 mW/cm$^2$, the rate of carbon oxide evolution per hour lies in a egion above a line represented by $y = 0.8x$ (wherein x is the specific surface area in m$^2$/g, and y is the rate of carbon oxide evolution in μmol/hr).

7. The particulate titanium oxide of any one of claims 1 to 5 which is doped with silicon, has a specific surface area of 3 to 40 m$^2$/g, and for which, when 5 ml of a 5% by volume aqueous solution of acetic acid and 50 mg of the particulate titanium oxide are placed in a sealed container having an inside diameter of 15 mm and, in a suspended state, are irradiated with 365 nm ultraviolet light at an exposure dose of 15 mW/cm$^2$, the rate of carbon oxide evolution per hour lies in the region above the line represented by $y = 0.8x$ (wherein x is the specific surface area in m$^2$/g, and y is the rate of carbon oxide evolution in μmol/hr).

8. A titanium oxide powder comprising an aggregation of numerous titanium oxide particles of any one of claims 1 to 7, wherein anatase-type crystals account for at least 80% of all the titanium oxide particles making up the powder.

9. The titanium oxide powder of claim 8, wherein anatase-type crystals account for at least 90% of the particles.

10. A method of manufacturing particulate titanium oxide which is **characterized by** feeding a titanium compound vapor and oxygen into a reaction tube and applying heat from outside the tube.

11. The method of manufacturing particulate titanium oxide of claim 10 which is **characterized by** using an oxyhydrogen flame burner as the heating source.

12. The method of manufacturing particulate titanium oxide of claim 10 or 11 which is **characterized by** rotating the reaction tube.

13. The method of manufacturing particulate titanium oxide of claim 10 which is **characterized by** providing in the reaction tube a cylindrical member for guiding a mixed gas of the titanium compound vapor and the oxygen to an inner wall side of the reaction tube, and by applying heat from outside the tube.

14. The method of manufacturing particulate titanium oxide of claim 13 which is **characterized by** providing a gap of 0.1 to 10 mm between the reaction tube and the cylindrical member.

15. The method of manufacturing particulate titanium oxide of any one of claims 10 to 14 which is **characterized in that** the particulate titanium oxide which has been produced is collected by using a thermophoretic effect to make it accumulate in a downstream portion of the reaction tube.

16. The method of manufacturing particulate titanium oxide of any one of claims 10 to 14 which is **characterized in that** the particulate titanium oxide which has been produced is collected using a bag filter provided on a downstream side of the reaction tube.

17. An apparatus for manufacturing particulate titanium oxide which comprises a reaction tube, a heating source for heating the reaction tube from the outside thereof, a rotary drive unit which rotates the reaction tube about its own axis, and a raw material feed unit which feeds a titanium compound vapor and oxygen into the reaction tube.

18. The particulate titanium oxide manufacturing apparatus of claim 17 which additionally comprises a bag filter that collects particulate titanium oxide which has been produced within the reaction tube.

19. The particulate titanium oxide manufacturing apparatus of claim 17 or 18, wherein a cylindrical member that guides a mixed gas of the titanium compound vapor and the oxygen to an inner wall side of the reaction tube is provided within the reaction tube.

20. A photocatalyst comprising the particulate titanium oxide of any one of claims 1 to 7.

21. A photocatalyst comprising the titanium oxide powder of claim 8 or 9.

22. A coating comprising the particulate titanium oxide of any one of claims 1 to 7.

23. A coating comprising the titanium oxide powder of claim 8 or 9.

24. A photocatalytic device comprising a photocatalytic reactant which supports on a surface thereof the particulate titanium oxide of any one of claims 1 to 7, and a light source which directs light at the photocatalytic reactant.

25. A method of decomposing noxious substances using the titanium oxide powder of claim 8 or 9.

26. The noxious substance decomposing method of claim 25, wherein decomposition is carried out by contacting particulate titanium oxide with a material to be treated, then separating off the particulate titanium oxide with a filter.

27. The contaminant decomposing method of claim 26, wherein the filter is made of glass fibers and has a pore size of at least 2.0 μm.

28. A deodorizing method which uses the photocatalyst of claim 20 or 21.

29. A sterilizing method which uses the photocatalyst of claim 20 or 21.

30. A method of decomposing noxious substances which uses the photocatalyst of claim 20 or 21.

## FIG. 1

## FIG. 2

# FIG. 3

# FIG. 4

# FIG. 5

# FIG. 6

FIG. 7

FIG. 8

# FIG. 9

FIG. 10

# FIG. 11

<table>
<tr><td colspan="2" align="center"><b>INTERNATIONAL SEARCH REPORT</b></td><td>International application No.<br>PCT/JP2004/000073</td></tr>
</table>

| A. CLASSIFICATION OF SUBJECT MATTER |
|---|
| Int.Cl$^7$ C30B29/16, C01G23/07 |

According to International Patent Classification (IPC) or to both national classification and IPC

| B. FIELDS SEARCHED |
|---|

Minimum documentation searched (classification system followed by classification symbols)
Int.Cl$^7$ C30B29/16, C01G23/07

Documentation searched other than minimum documentation to the extent that such documents are included in the fields searched
| | | | |
|---|---|---|---|
| Jitsuyo Shinan Koho | 1922–1996 | Toroku Jitsuyo Shinan Koho | 1994–2004 |
| Kokai Jitsuyo Shinan Koho | 1971–2004 | Jitsuyo Shinan Toroku Koho | 1996–2004 |

Electronic data base consulted during the international search (name of data base and, where practicable, search terms used)
CAS ONLINE, JSTPlus(JOIS)

| C. DOCUMENTS CONSIDERED TO BE RELEVANT | | |
|---|---|---|
| Category* | Citation of document, with indication, where appropriate, of the relevant passages | Relevant to claim No. |
| X<br>A | JP 2001-287996 A (Toho Titanium Co., Ltd.),<br>16 October, 2001 (16.10.01),<br>Claims 1 to 4; Par. Nos. [0002], [0015], [0025],<br>[0030]; Fig. 1<br>(Family: none) | 1-11,20-30<br>12-19 |
| X<br>A | JP 2001-276615 A (Michio MATSUMURA et al),<br>09 October, 2001 (09.10.01),<br>Claims 1 to 5; Par. Nos. [0002], [0012], [0020]<br>(Family: none) | 1-11,20-30<br>12-19 |
| X<br>A | JP 2000-239020 A (Sumitomo Chemical Co., Ltd.),<br>05 September, 2000 (05.09.00),<br>Claims 1 to 6<br>(Family: none) | 1-9<br>10-30 |

| ☐ Further documents are listed in the continuation of Box C. | ☐ See patent family annex. |
|---|---|

| | |
|---|---|
| * Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| Date of the actual completion of the international search<br>02 April, 2004 (02.04.04) | Date of mailing of the international search report<br>20 April, 2004 (20.04.04) |
| Name and mailing address of the ISA/<br>Japanese Patent Office | Authorized officer |
| Facsimile No. | Telephone No. |

Form PCT/ISA/210 (second sheet) (July 1998)